(19) **Europäisches Patentamt**
**European Patent Office**
**Office européen des brevets**

(11) **EP 1 231 515 B1**

(12) **EUROPEAN PATENT SPECIFICATION**

(45) Date of publication and mention
of the grant of the patent:
**05.11.2008 Bulletin 2008/45**

(51) Int Cl.:
***G03F 7/20*** (2006.01)

(21) Application number: **02250785.9**

(22) Date of filing: **06.02.2002**

(54) **Lithographic apparatus and device manufacturing method**

Lithographischer Apparat und Verfahren zur Herstellung einer Vorrichtung

Appareil lithographique et méthode de fabrication d'un dispositif

(84) Designated Contracting States:
**DE FR GB IT NL**

(30) Priority: **08.02.2001 EP 01301116**

(43) Date of publication of application:
**14.08.2002 Bulletin 2002/33**

(73) Proprietor: **ASML Netherlands B.V.**
**5504 DR Veldhoven (NL)**

(72) Inventors:
• **Boonman, Marcus Emile Joannes**
**5508 GA Veldhoven (NL)**
• **Mulkens, Johannes Catharinus Hubertus**
**6211 LP Maastricht (NL)**
• **Butler, Hans**
**5685 AC Best (NL)**

(74) Representative: **Leeming, John Gerard**
**J.A. Kemp & Co.**
**14 South Square**
**Gray's Inn**
**London WC1R 5JJ (GB)**

(56) References cited:
EP-A- 0 480 616        US-A- 5 142 132
US-A- 5 202 748

• **PATENT ABSTRACTS OF JAPAN vol. 011, no. 027 (E-474), 27 January 1987 (1987-01-27) -& JP 61 196532 A (CANON INC), 30 August 1986 (1986-08-30)**

Remarks:
The file contains technical information submitted after the application was filed and not included in this specification

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate, said projection system having a focal plane and comprising at least one adjustable element capable of changing the shape of the focal plane.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

To correctly image the mask pattern onto the substrate it is necessary to position the wafer accurately in the focal plane of the projection lens. The position of the focal plane can vary according to the position of the mask, illumination and imaging settings in the illumination and projection systems and due to, for example, temperature and/or pressure variations in the apparatus, during a series of exposures. To deal with these variations in focal plane position, it is known to measure the vertical position of the focal plane using a sensor such as a transmission image sensor (TIS) or a reflection image sensor (RIS) and then position the wafer surface in the focal plane. This can be done using so-called "on-the-fly" levelling whereby a level sensor measures the vertical position of the wafer surface during the exposure and adjusts the height and/or tilt of the wafer table to optimise the imaging performance, Alternatively, so-called "off-axis" levelling can be used. In this method, a height map of (a part of) the wafer surface is taken, e.g. in a multi-stage apparatus, in advance of the exposure and height and tilt set points for the exposure, or series of exposures, to optimise the focus according to defined criteria, are calculated in advance. Methods and a system for such off-axis levelling are described in European Patent Application EP-A-1 037 117. In the off-axis method, it is proposed that the exact shape and position of the wafer surface can be measured and the wafer height and tilt positions for the exposure can then be optimised to minimise defocus predicted relative to that measured wafer surface. Since the focal plane of the projection system will generally be flat and the wafer surface will generally not be flat, there will always be some residual defocus which cannot be compensated for by levelling procedures.

US 5,202,748A discloses a lithographic projection apparatus in which the substrate being exposed is deformed to be more flat and aberrations in the optical train are reduced by adjusting a deformable turning mirror.

US 5,142,132 discloses a semiconductor wafer stepper including an interferometer camera to provide depth of focus and aberration information which is used to control a deformable mirror.

An object of the present invention is to provide a system and a method for controlling a lithographic projection apparatus to further improve focus across the entire exposure area.

This and other objects are achieved according to the invention in a lithographic projection apparatus and a device manufacturing method as defined in the appended claims.

As discussed above, prior art methods in which the focal plane is generally arranged to be as flat as possible and the substrate height and/or tilt are controlled to minimise defocus, inevitably leave some residual defocus as the wafer surface is generally not exactly flat. According to the present invention, rather than attempting to make the focal plane exactly flat, its shape is deliberately changed to make it conform more closely to the measured surface contour of the substrate in the exposure area to be exposed. Preferably, control of the wafer height and tilt is integrated with control of the shape of the focal plane. Then, low order (height & tilt) corrections can be effected by positioning the substrate and high order corrections can be effected by adjustments to the shape of the focal plane. Also, low order effects of high order adjustments to the shape of the focal plane can be compensated for in positioning of the substrate.

The present invention can therefore provide improved imaging by reducing defocus across the entire exposure area. This improves imaging quality on all exposure areas and also makes possible focussing on exposure areas having curved surfaces that would previously have exceeded defocus limits.

The present invention can make use of all available manipulators in the projection system to adjust elements that affect the shape of the focal plane. Such manipulators are provided with suitable actuators, e.g. motors, piezoelectric actuators, solenoids, etc., to enable the control means to adjust the elements to which the manipulators are connected. The adjustable elements may include elements specifically provided for the present invention or provided for other purposes such as correcting field curvature introduced by changes in magnification, or correcting astigmatisms in the lenses. The adjustable elements may have their position and/or orientation in any of the six degrees of freedom changed by the manipulators. Additionally, it is possible to adjust the shape of the element.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of ultraviolet radiation (*e.g.* with a wavelength of 365, 248, 193, 157 or 126 nm).

The invention and its attendant advantages will be further described below with reference to exemplary embodiments and the accompanying schematic drawings, in which:

Figure 1 depicts a lithographic projection apparatus according to a first embodiment of the invention;
Figure 2 is a view showing how the wafer height is determined from measurements by the level sensor and the Z-interferometer;
Figures 3 to 6 are views showing various steps of the focus control and leveling procedure according to the present invention;
Figure 7 is a plan view of a substrate table showing the sensors and fiducials used in the focus control and leveling procedure according to the present invention;
Figure 8 is a view showing adjustable elements in the projection lens used in the present invention; and
Figure 9 is a diagram of a control system for putting the present invention into effect.

In the drawings, like references indicate like parts.

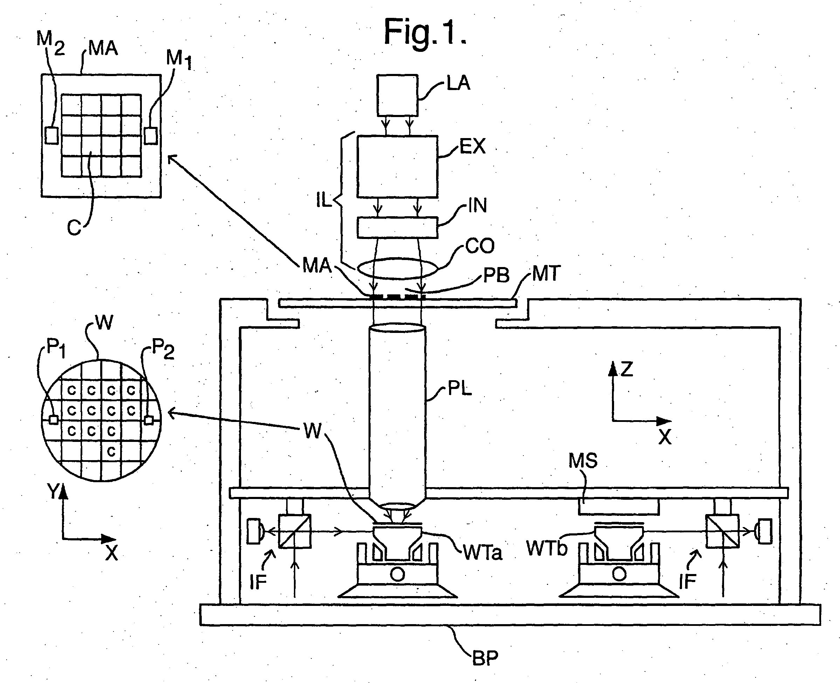

Figure 1 schematically depicts a lithographic projection apparatus according to a particular embodiment of the invention. The apparatus comprises:

· a radiation system LA, IL (EX, IN, CO), for supplying a projection beam PB of radiation (*e.g.* UV or EUV radiation). In this particular case, the radiation system also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WTa provided with a substrate holder for holding a substrate W (*e.g.* a resist-coated silicon wafer), and connected to second positioning means for accurately positioning the substrate with respect to item PL;
· a third object table (substrate or wafer table) WTb provided with a substrate holder for holding a substrate W (*e.g.* a resist-coated silicon wafer), and connected to third positioning means for accurately positioning the substrate with respect to item PL;
· a measurement system MS for performing measurement (characterization) processes on a substrate held on a substrate table WTa or WTb at a measurement station
· a projection system ("lens") PL (*e.g.* a refractive or catadioptric system) for imaging an irradiated portion of the mask MA onto a target portion C (*e.g.* comprising one or more dies) of the substrate W held on a substrate table WTa or WTb at an exposure station.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* a Hg lamp or an excimer laser) produces a beam of radiation. This beam is fed into an illumination system (illuminator) IL, either directly or after having traversed conditioning means, such as a beam expander EX, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the interferometric measuring means IF, the substrate tables WTa, WTb can be moved accurately by the second and third positioning means, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WTa, WTb will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The second and third positioning means may be constructed so as to be able to position their respective substrate tables WTa, WTb over a range encompassing both the exposure station under projection system PL and the measurement station under the measurement system MS. Alternatively, the second and third positioning means may be replaced by separate exposure station and measurement station positioning systems for positioning a substrate table in the respective exposure stations and a table exchange means for exchanging the substrate tables between the two positioning systems. Suitable positioning systems are described, inter alia, in WO 98/28665 and WO 98/40791 mentioned above. It should be noted that a lithography apparatus may have multiple exposure stations and/or multiple measurement stations and that the numbers of measurement and exposure stations may be different than each other and the total number of stations need not equal the number of substrate tables. Indeed, the principle of separate exposure and measurement stations may be employed even with a single substrate table.

The depicted apparatus can be used in two different modes:

1. In step mode, the mask table MT is kept essentially stationary, and an entire mask image is projected in one go (*i.e.* a single "flash") onto a target portion C. The substrate table WTa or WTb is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WTa or WTb is simultaneously moved in the same or opposite direction at a speed $V = Mv$, in which $M$ is the magnification of the lens PL (typically, $M$ = 1/4 or 1/5). In this manner, a relatively large target portion C can be exposed, without having to compromise on resolution.

An important factor influencing the imaging quality of a lithographic apparatus is the accuracy with which the mask image is focused on the substrate. Wafers are generally polished to a very high degree of flatness but nevertheless deviations of the wafer surface from perfect flatness (referred to as "unflatness") of sufficient magnitude noticeably to affect focus accuracy can occur. Unflatness may be caused, for example, by variations in wafer thickness, distortion of the shape of the wafer or contaminants on the substrate table. The presence of structures due to previous process steps also significantly affects the wafer height (flatness). In the present invention, the cause of unflatness is largely irrelevant; only the height of the top surface of the wafer is considered. Unless the context otherwise requires, references below to "the wafer surface" refer to the top surface of the wafer onto which will be projected the mask image.

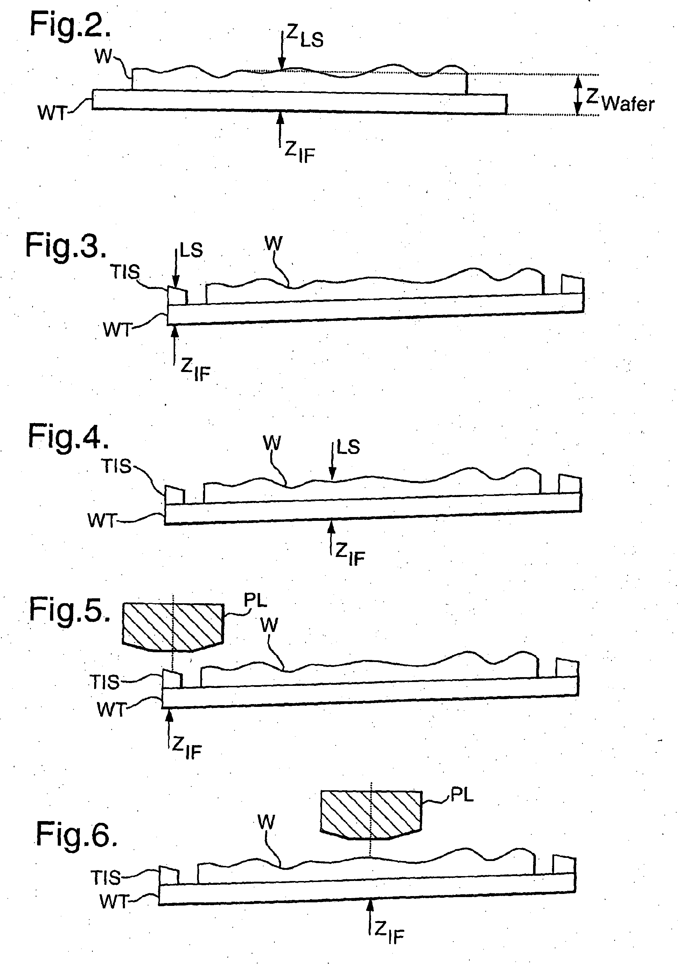

After loading a wafer onto one of the substrate tables WTa, WTb, the height of the wafer surface ZWafer relative to a physical reference surface of the substrate table is mapped. This process is carried out at the measurement station using a first sensor, referred to as the level sensor, which measures the vertical (Z) position of the physical reference surface and the vertical position of the wafer surface, ZLS, at a plurality of points, and a second sensor, for example a Z-interferometer, which simultaneously measures the vertical position of the substrate table, ZIF at the same points. As shown in Figure 2, the wafer surface height is determined as ZWafer = ZLS - ZIF. The substrate table carrying the wafer is then transferred to the exposure station and the vertical position of the physical reference surface is again determined. The height map is then referred to in positioning the wafer at the correct vertical position during the exposure process. This procedure is described in more detail below with reference to Figures 3 to 6.

As shown in Figure 3, first the substrate table is moved so that a physical reference surface fixed to the substrate table is underneath the level sensor LS. The physical reference surface may be any convenient surface whose position in X, Y and Z on the substrate table will not change during processing of a wafer in the lithographic apparatus and, most importantly, in the transfer of the substrate table between measurement and exposure stations. The physical reference surface may be part of a fiducial containing other alignment markers and the surface should have such properties as to allow its vertical position to be measured by the same sensor as measures the vertical position of the wafer surface. The physical reference surface may be a reflective surface in a fiducial in which is inset a so-called transmission image sensor (TIS). The TIS is described further below.

The level sensor may be, for example, an optical sensor; alternatively, pneumatic or capacitive sensors (for example) are conceivable. A presently preferred form of sensor making use of Moiré patterns formed between the image of a projection grating reflected by the wafer surface and a fixed detection grating is described in European Patent Application EP-A-1 037 117. The level sensor should preferably measure the vertical position of a plurality of positions on the wafer surface simultaneously and for each position the sensor may measure the average height of a particular area, so averaging out unflatnesses of high spatial frequencies.

Simultaneously with the measurement of the vertical position of a physical reference surface by the level sensor LS, the vertical position of the substrate table is measured using the Z-interferometer, ZIF. The Z-interferometer may, for example, be part of a three, five or six-axis interferometric metrology system such as that described in WO 99/28790 or WO 99/32940, which documents are incorporated herein by reference. The Z-interferometer system preferably measures the vertical position of the substrate table at a point having the same position in the XY plane as the calibrated measurement position of the level sensor LS. This may be done by measuring the vertical position of two opposite sides of the substrate table WT (WTa or WTb) at points in line with the measurement position of the level sensor and interpolating/modeling between them. This ensures that, in the event that the substrate table is tilted out of the XY plane, the Z-interferometer measurement correctly indicates the vertical position of the substrate table under the level sensor.

Preferably, this process is repeated with at least a second physical reference surface spaced apart, e.g. diagonally, from the first physical reference surface. Height measurements from two or more positions can then be used to define a reference plane.

The simultaneous measurement of the vertical position of one or more physical reference surfaces and the vertical position of the substrate table establishes a point or points determining the reference plane relative to which the wafer height is to be mapped. A Z-interferometer of the type mentioned above is effectively a displacement sensor rather than an absolute sensor, and so requires zeroing, but provides a highly linear position measurement over a wide range. On the other hand, suitable level sensors, e.g. those mentioned above, may provide an absolute position measurement with respect to an externally defined reference plane (i.e. nominal zero) but over a smaller range. Where such sensors are used, it is convenient to move the substrate table vertically under the level sensor until the physical reference surface (s) is (are) positioned at a nominal zero in the middle of the measurement range of the level sensor and to read out the current interferometer Z value. One or more of these measurements on physical reference surfaces will establish the reference plane for the height mapping. The Z-interferometer is then zeroed with reference to the reference plane. In this way the reference plane is related to the physical surface on the substrate table and the ZWafer height map is made independent of the initial zero position of the Z-interferometer at the measurement station and other local factors such as any unflatness in the base plate over which the substrate table is moved. Additionally, the height map is made independent of any drift in the zero position of the level sensor.

As illustrated in Figure 4, once the reference plane has been established, the substrate table is moved so that the wafer surface is scanned underneath the level sensor to make the height map. The vertical position of the wafer surface and the vertical position of the substrate table are measured at a plurality of points of known XY position and subtracted from each other to give the wafer height at the known XY positions. These wafer height values form the wafer height map which can be recorded in any suitable form. For example, the wafer height values and XY coordinates may be stored together in so-called indivisible pairs. Alternatively, the points at which wafer height values are taken may be predetermined, e.g. by scanning the wafer along a predetermined path at a predetermined speed and making measurements at predetermined intervals, so that a simple list or array of height values (optionally together with a small number of parameters defining the measurement pattern and/or a starting point) may suffice to define the height map.

The motion of the substrate table during the height mapping scan is largely only in the XY plane. However, if the level sensor LS is of a type which only gives a reliable zero reading, the substrate table is also moved vertically to keep the wafer surface at the zero position of the level sensor. The wafer height is then essentially derived from the Z movements of the substrate table, as measured by the Z-interferometer, necessary to maintain a zero readout from the level sensor. However, it is preferable to use a level sensor that has an appreciable measurement range over which its output is linearly related to wafer height, or can be linearized. Such measurement range ideally encompasses the maximum expected, or permissible, variation in wafer height.

With such a sensor, the need for vertical movement of the substrate table during the scan is reduced or eliminated and the scan can be completed faster, since the scan speed is then limited by the sensor response time rather than by the ability of the short stroke positioning of the substrate table to track the contour of the wafer in three dimensions. Also, a sensor with an appreciable linear range can allow the heights at a plurality of positions (e.g. an array of spots) to be measured simultaneously.

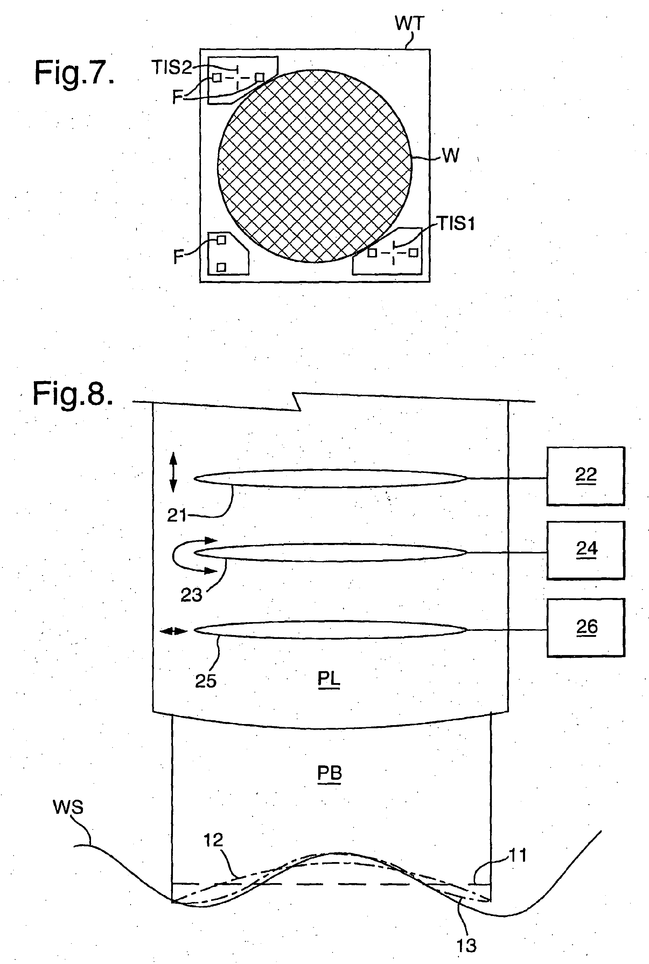

Next, the wafer table is moved to the exposure station and, as shown in Figure 5, the (physical) reference surface is positioned under the projection lens so as to allow a measurement of its vertical position relative to a reference point in the focal plane of the projection lens. In a preferred embodiment, this is achieved using one or more transmission image sensors (described below) whose detector is physically connected to the reference surface used in the earlier measurements. The transmission image sensor(s) can determine the vertical focus position of the projected image from the mask under the projection lens. Armed with this measurement, the reference plane can be related to the focal plane of the projection lens and an exposure scheme which keeps the wafer surface in optimum focus can be determined. In the prior art this is done by calculating a path for the substrate table in three-dimensions, e.g. defined by Z, Rx and Ry setpoints for a series of points along the scan path. This is shown in Figure 6. According to the present invention, the shape of the focal plane is also adjusted to improve the focus using available manipulators in the projection lens. This is shown in Figure 8.

As can be seen in Figure 8, if the wafer surface WS includes significant unflatness, it is impossible to bring it into correct focus in a flat focal plane 11 across the entire area of the exposure slit of the projection beam PB. Instead, it is necessary to position the wafer at a position that minimizes the total or average defocus between the wafer surface WS and the flat focal plane 11. According to the invention, the residual defocus can be minimized or eliminated by distorting the focal plane using available manipulators 22, 24, 26 in the projection system PL. Such manipulators 22, 24, 26 may adjust the vertical, horizontal and/or rotational positions of elements 21, 23, 25 in the projection systems. The manipulators used in the present invention may be provided for on-site adjustment of the projection lens, for compensating for transient effects, e.g. lens heating caused by the projection beam, or specifically for the present invention. Lens elements used to correct field curvature caused by adjustments in the magnification of the system are particularly useful in the present invention. According to the invention, the field curvature corrections can be changed, or field curvature deliberately introduced to improve focus on a non-flat substrate. Of course, any other available manipulators which change the (relative) position and/or orientation of one or more lens elements may be used. The invention may also make use of manipulators which change the shape and/or optical properties of elements in the projection system.

The degree of improvement afforded by the present invention will depend on the wafer surface and the number and effect of the available manipulators. As can be seen in Figure 8, introducing a second order correction results in a focal plane 12 which is closer to the illustrated wafer surface and hence has a reduced defocus. Introducing a fourth order correction results in a focal plane 13 even closer to the wafer surface WS and hence further reduced defocus. If the projection system includes asymmetric elements and suitable manipulators, higher odd order corrections can also be made.

According to the invention, setpoints for p1, p2, etc., where p1, p2, etc. are adjustable parameters of the projection system PL, are determined in addition to setpoints for Z, Rx and Ry. The setpoints can be determined using a least squares method so as to minimize the difference between the wafer map data and the focus plane of the exposure slit image, during the scanning motion. For ease of calculation, the relative motion of the exposure slit image and wafer can be expressed as the slit moving relative to a static wafer. The least squares criterion can then be expressed as, for each time t, finding the values Z(t), Rx(t), Ry(t), p1(t), p2(t), ... etc. which give a minimum value of:

$$LSQ(t) = \frac{1}{s.W} \int_{-s/2}^{+s/2} \int_{-W/2}^{+W/2} \left[ w(x, y, Z(t), x.Ry(t), y.Rx(t)) - FP(p1(t), p2(t), etc.) \right]^2 dxdy \quad (1)$$

where $w(x,y,$ etc.$)$ defines the vertical position of the wafer surface, FP(p1(t), p2(t), etc.) defines the vertical position of the focal plane as a function of p1(t), p2(t), etc , s is the width of the exposure slit in the scanning direction and $W$ its length perpendicular to the scanning direction. The setpoints and the wafer trajectory can be expressed as functions of either Y (position in the scanning direction) or t (time) since these are related by $Y = y_0 + v.t$, where $y_0$ is the starting position and v is the scanning speed.

As mentioned above, the physical reference surface(s) is (are) preferably a surface in which a transmission image sensor (TIS) is inset. As shown in Figure 7, two sensors TIS1 and TIS2 are mounted on a fiducial plate mounted to the top surface of the substrate table (WT, WTa or WTb), at diagonally opposite positions outside the area covered by the wafer W. The fiducial plate is made of a highly stable material with a very low coefficient of thermal expansion, e.g. Invar, and has a flat reflective upper surface which may carry markers used in alignment processes. TIS1 and TIS2 are sensors used to determine directly the vertical (and horizontal) position of the aerial image of the projection lens. They comprise apertures in the respective surface close behind which is placed a photodetector sensitive to the radiation used for the exposure process. To determine the position of the focal plane, the projection lens projects into space an image of a TIS pattern TIS-M provided on the mask MA and having contrasting light and dark regions. The substrate table is then scanned horizontally (in one or preferably two directions) and vertically so that the aperture of the TIS passes through the space where the aerial image is expected to be. As the TIS aperture passes through the light and dark portions of the image of the TIS pattern, the output of the photodetector will fluctuate. This procedure is repeated at different vertical levels. The position at which the rate of change of amplitude of the photodetector output is highest indicates the position at which the image of TIS pattern has the greatest contrast and hence indicates the position of optimum focus. Thereby, a three-dimensional map of the focal plane can be derived. An example of a TIS of this type is described in greater detail in US 4,540,277, incorporated herein by reference. Instead of the TIS, a Reflection Image Sensor (RIS) such as that described in US 5,144,363, incorporated herein by reference, may also be used.

Using the surface of the TIS as the physical reference surface has the advantage that the TIS measurement directly relates the reference plane used for the height map to the focal plane of the projection lens, and so the height map can be employed directly to give height corrections for the substrate table during the exposure process. This is illustrated in Figure 6, which shows the substrate table WT as positioned under the control of the Z-interferometer at a height determined by the height map so that the wafer surface is at the correct position under the projection lens PL.

The TIS surface may additionally carry reference markers whose position is detected using a through-the-lens (TTL) alignment system to align the substrate table to the mask. Such an alignment system is described in EP-0 467 445 A, incorporated herein by reference, for example. Alignment of individual exposure areas can also be carried out, or may be obviated by an alignment procedure carried out at the measurement stage to align the exposure areas to the reference markers on the substrate table. Such a procedure is described in EP-0 906 590 A, incorporated herein by reference, for example.

With knowledge of the location and extent of the intended exposure areas, the height map generated by the present invention can be used to calculate in advance optimum Z, Rx, Ry, p1, p2, etc. position setpoints for the substrate table or projection system for each exposure. This avoids the time required for leveling in known apparatus that only measure wafer height when the wafer is positioned under the projection lens, and hence increases throughput. The optimum Z, Rx, Ry, p1, p2, etc. setpoints may be calculated by various known mathematical techniques, for example using an iterative process to minimize defocus (defined as the distance between the wafer surface and the ideal focal plane), LSQ(t), integrated over the exposure area.

A further advantage is possible in the step-and-scan mode. In this mode, the projection lens projects an image of only part of the mask pattern onto a corresponding part of the exposure area. The mask and substrate are then scanned in synchronism through the object and image focal planes of the projection system PL so that the entire mask pattern is imaged onto the whole exposure area. Although in practice the projection lens is held stationary and the mask and substrate are moved, it is often convenient to consider this process in terms of an image slit moving over the wafer surface. With the height map determined in advance by the present invention, it is possible to calculate a sequence of Z, Rx, Ry, p1, p2, etc. setpoints matched to the XY scan path (usually, scanning takes place in only one direction, e.g. Y). The sequence of setpoints can be optimized according to additional criteria, e.g. to minimize vertical accelerations or tilt motions that might reduce throughput or induce undesirable vibrations. Given a sequence of spaced-apart setpoints, a scanning trajectory for the exposure can be calculated using a polynomial or spline fitting procedure.

Whilst the present invention aims to position the wafer at the optimum position in Z, Rx and Ry and adjust the shape of the focal plane for a given exposure, the variations in wafer surface height over the exposure area may be such that the wafer cannot be positioned and the focal plane shaped to give adequate focus over the entire area. Such so-called focus spots can result in an exposure failure. However, with the present invention such failures can be predicted in advance and remedial action can be taken. For example, the wafer may be stripped and recoated without the detrimental effect of further processing a badly exposed wafer. Alternatively, if the predicted failure affects only one or a few devices on the wafer whilst others will be acceptable, throughput may be enhanced by skipping exposures that can be predicted in advance to result in defective devices.

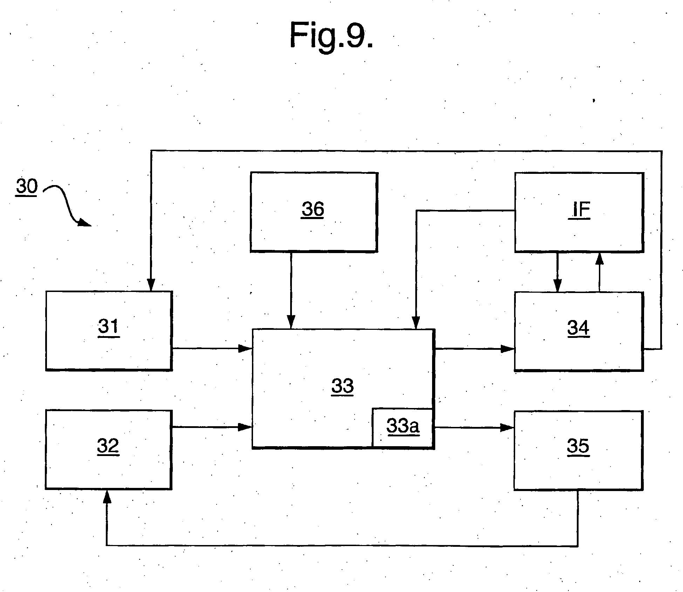

A control system 30 used in implementing the present invention is shown in Figure 9. In Figure 9, data describing the wafer surface is supplied by wafer height map 31, which may comprise a memory in which a previously derived wafer height map has been stored, or a level sensor directly measuring the wafer surface, in real time, and data describing the focal plane from focal plane map 32. Since it is generally impractical to continuously measure the configuration of the focal plane, the focal plane map 32 is generally a memory storing the results of periodic measurements of the focal plane shape, supplemented as necessary by a model of how the focal plane changes with varying imaging parameters. Where continuous or quasi-continuous measurement of the focal plane is possible, that may also be used. The data describing the wafer surface and the focal plane shape is used by controller 33 to calculate setpoints for the substrate table position (Z, Rx and Ry) and projection lens parameters (p1, p2, etc.) which are supplied to servo controller 34 for table positioning and servo controller 35 for control of the manipulators 22, 24, 26 of the projection system PL. The table positioning servo controller 34 may employ a feedback control using the table position as measured by the interferometric displacement measuring system IF. The table position can also be used to control read-out from a memory 33a of setpoints calculated in advance. The adjustments to projection system parameters p1, p2, etc. can be fed back from the servo controller 35 to the focal plane map 32. The projection system may, as mentioned above, also be subject to adjustment to compensate for other, particularly transient, effects such as lens heating. Corrections to the projection system to effect the necessary compensations for such effects can be supplied by relevant control systems 36 and combined with adjustments for leveling and focusing according to the invention.

The control system 30 also includes a feedback from wafer height map 31 to servo controller 34 to allow control of the substrate table position in real time (on-the-fly). This feedback can be omitted if only off-axis leveling - in which the substrate table positions during the scan are stored in advance in memory - is to be performed.

How the necessary adjustments to arrive at optimum focus are divided among the different adjustable parameters will be determined as the invention is implemented in a specific apparatus. In many apparatus, the range of adjustment of the substrate table and its speed of response will be greater than those of the adjustable elements in the projection system. In such a case it can be convenient to separate the $0^{th}$ and $1^{st}$ order corrections from the higher order corrections and position the substrate table to correct for these; the $0^{th}$ and $1^{st}$ order correction are effectively height and tilt corrections whereas the higher order corrections represent variations in the wafer surface within the exposure slit which cannot therefore be compensated for by changing the height or tilt of the wafer surface. Although it is preferred to utilize the substrate table to perform the $0^{th}$ or $1^{st}$ order correction, it is also contemplated that these corrections are performed by adjusting adjustable elements in the projection system. Where separation of $0^{th}$ and $1^{st}$ order from higher order correction is utilized, the separation may be done in the input data. For example, it would be possible to subtract the wafer surface and focal plane to derive a correction surface and for each exposure or point in the exposure path, then fit a flat, but inclined plane to the correction surface. The height of that flat plane at the center of the exposure slit determines the. necessary height correction ($0^{th}$ order) and its inclination gives the necessary tilt corrections ($1^{st}$ order). The flat inclined plane is then subtracted from the correction surface leaving the higher orders for correction by adjustment of the projection lens parameters.

In some apparatus, adjustment of the projection lens parameters to achieve desired higher order corrections may cause unavoidable changes in the vertical position and inclination ($0^{th}$ and $1^{st}$ order) of the focal plane. Where such crosstalk between the higher and lower order corrections occurs, an integrated control algorithm, rather than separation of the higher and lower orders, may be preferable. Alternatively, higher order corrections may be calculated first and any consequential effects in the lower order fed across into calculation of the necessary lower order corrections.

In scanning apparatus having an exposure slit that is relatively narrow in the scanning direction as compared to its width in the transverse direction (perpendicular to the scanning direction) and having mainly rotationally symmetric elements in the projection lens, the higher order corrections in particular may be performed mainly to compensate for the wafer surface shape in the transverse direction. This is because, with symmetric elements in the projection system, separate changes to the shape of the focal plane in the scanning and transverse directions are impossible. Thus, a change in the curvature of the focal plane in the transverse direction would result in a change in the scanning direction but because of the greater dimension of the exposure slit in the transverse direction, the curvatures that are necessary to compensate for deviations in the transverse direction would only result in small vertical deviations at the extremes in the scanning direction. Further, focus deviations in the scanning direction are averaged out by the scanning motion, and in many cases can therefore be disregarded.

Where the wafer shape is primarily determined by previous process layers and a number of similar or identical dies are to be printed on one or more wafers, it may be possible to predict or calculate corrections only once for each die type in a wafer or batch of wafers. In some cases, the higher order wafer shape may be determined by previous process layers but superimposed on height and tilt variations across and between wafers and/or exposure areas. In such a case, the higher order corrections for each die type may be calculated in advance and combined with lower order corrections calculated for each exposure area.

Whilst we have described above specific embodiments of the invention it will be appreciated that the invention may be practiced otherwise than as described. The description is not intended to limit the invention.

**Claims**

1. A lithographic projection apparatus comprising:

   a radiation system (EX, IN, CO) for supplying a projection beam of radiation;
   a support structure (MT) for supporting patterning means serving to pattern the projection beam according to a desired pattern;
   a substrate table (WT) for holding a substrate (W);
   a projection system (PL) for projecting the patterned beam onto an exposure area of the substrate, said projection system having a focal plane and comprising at least one adjustable element (21, 23, 25) capable of changing the shape of the focal plane; and
   control means (30) arranged to operate during exposure of an exposure area by projection of said patterned beam thereon to control said adjustable element to change the shape of said focal plane so as to be less flat and to more closely conform to the surface contour of said exposure area; **characterised in that**

said adjustable element is a refractive lens element (21, 23, 25).

2. Apparatus according to claim 1 wherein said control means comprises a memory for storing data (31) representative of said surface contour.

3. Apparatus according to claim 2 wherein said apparatus further comprises a measurement station (MS) having substrate height mapping means arranged to operate in advance of an exposure to measure the substrate surface contour of at least one exposure area, for storage in said memory.

4. Apparatus according to claim 2 wherein said control means (30) further comprises an interface for receiving data representative of said surface contour from an external device.

5. Apparatus according to claim 2, 3 or 4 wherein said control means (30) is arranged to calculate desired adjustments to said adjustable element for a given exposure in advance of that exposure.

6. Apparatus according to claim 1 wherein said apparatus further comprises a sensor for measuring the position of the substrate surface at a plurality of points in said exposure area during an exposure.

7. Apparatus according to any one of the preceding claims further comprising positioning means for moving said substrate table (WT) to position the substrate at a desired position and/or orientation and wherein said control means (30) is also operative to control said positioning means to position the substrate.

8. Apparatus according to claim 7 wherein said control means (30) is adapted to control said positioning means to effect low order corrections to bring the surface of said substrate (W) at said exposure area into closer conformity with said focal plane and to control said adjustable element to effect high order corrections.

9. Apparatus according to claim 8 wherein said low order corrections comprise position and orientation corrections.

10. Apparatus according to claim 8 or 9 wherein said control means (30) is adapted to control said positioning system to effect low order corrections to compensate for low order effects caused by adjustments of said adjustable element.

11. Apparatus according to any one of the preceding claims wherein said adjustable element (21, 23, 25) is a field-curvature correction lens.

12. A device manufacturing method comprising the steps of:

> providing a substrate (W) that is at least partially covered by a layer of radiation-sensitive material;
> providing a projection beam of radiation using a radiation system (EX, IN, CO);
> using patterning means (MA) to endow the projection beam with a pattern in its cross-section;
> projecting the patterned beam of radiation onto an exposure area of the layer of radiation-sensitive material using a projection system (PL), said projection system having a focal plane and comprising at least one adjustable element (21, 23, 25) capable of changing the shape of the focal plane; and
> controlling said adjustable element (21, 23, 25), during the step of projecting the patterned beam onto an exposure area, to change the shape of said focal plane so as to be less flat and to more closely conform to the surface contour of said exposure area; **characterised in that**:

> said adjustable element is a refractive lens element (21, 23, 25).

13. A method according to claim 12 further comprising the step of measuring the surface contour of said exposure area in advance of the step of imaging.

14. A method according to claim 13 wherein said step of measuring is performed using a measurement station (MS) in the lithographic apparatus or a separate qualification tool.

15. A method according to claim 13 or 14 further comprising the step of calculating adjustments to the adjustable element (21, 23, 25) for imaging a given exposure area in advance of the step of imaging that exposure area.

16. A method according to claim 15 wherein a plurality of similar exposure areas are imaged and adjustments calculated in said step of calculating adjustments are used in imaging a plurality of exposure areas.

**Patentansprüche**

1. Lithographische Projektionsvorrichtung, mit:

   • einem Strahlungssystem (EX, IN, CO) zum Bereitstellen eines Projektionsstrahls aus Strahlung;
   • einer Haltekonstruktion (MT) zum Halten von Musteraufbringungseinrichtungen, die dazu dienen, den Projektionsstrahl gemäß einem gewünschten Muster zu mustern;
   • einem Substrattisch (WT) zum Halten eines Substrats;
   • einem Projektionssystem (PL) zum Projizieren des gemusterten Strahls auf einen Belichtungsbereich des Substrats, wobei das Projektionssystem eine Fokalebene aufweist und wenigstens ein Einstellelement (21, 23, 25) umfasst, das die Form der Fokalebene ändern kann; und
   • einer Steuereinrichtung (30), die so angeordnet ist, dass sie während der Belichtung eines Belichtungsbereichs durch Projizieren des gemusterten Strahls darauf arbeitet, um das Einstellelement zu steuern, damit die Form der Fokalebene so geändert wird, dass sie weniger flach ist und mit der Oberflächenkontur des Belichtungsbereichs genauer übereinstimmt; **dadurch gekennzeichnet, dass**

   das Einstellelement ein brechendes Linsenelement (21, 23, 25) ist.

2. Vorrichtung nach Anspruch 1, wobei die Steuereinrichtung einen Speicher zum Speichern von Daten (31) umfasst, die die Oberflächenkontur repräsentieren.

3. Vorrichtung nach Anspruch 2, wobei die Vorrichtung ferner eine Messstation (MS) umfasst, die eine Substrathöhen-Abbildungseinrichtung aufweist, die so angeordnet ist, dass sie vor einer Belichtung arbeitet, um die Substratoberflächenkontur von wenigstens einem Belichtungsbereich für die Speicherung im Speicher zu messen.

4. Vorrichtung nach Anspruch 2, wobei die Steuereinrichtung (30) ferner eine Schnittstelle umfasst, um Daten, die die Oberflächenkontur repräsentieren, von einem externen Bauteil zu empfangen.

5. Vorrichtung nach Anspruch 2, 3 oder 4, wobei die Steuereinrichtung (30) so angeordnet ist, dass sie gewünschte Einstellungen für das Einstellelement für eine bestimmte Belichtung vor dieser Belichtung berechnet.

6. Vorrichtung nach Anspruch 1, wobei die Vorrichtung ferner einen Sensor umfasst, der während einer Belichtung die Position der Substratoberfläche bei einer Vielzahl von Punkten in dem Belichtungsbereich misst.

7. Vorrichtung nach einem der vorhergehenden Ansprüche, ferner mit einer Positionierungseinrichtung zum Bewegen des Substrattisches (WT), um das Substrat bei einer gewünschten Position und/oder Ausrichtung zu positionieren und wobei die Steuereinrichtung (30) auch arbeitet, um die Positionierungseinrichtung für eine Positionierung des Substrats zu steuern.

8. Vorrichtung nach Anspruch 7, wobei die Steuereinrichtung (30) so angepasst ist, dass sie die Positionierungseinrichtung steuert, um niederwertige Korrekturen zu bewirken, damit die Oberfläche des Substrats (W) bei dem Belichtungsbereich mit der Fokalebene genauer übereinstimmt, und um das Einstellelement zu steuern, um höherwertige Korrekturen zu bewirken.

9. Vorrichtung nach Anspruch 8, wobei die niederwertigen Korrekturen Positions- und Ausrichtungskorrekturen umfassen.

10. Vorrichtung nach Anspruch 8 oder 9, wobei die Steuereinrichtung (30) so angepasst ist, dass sie das Positionierungssystem steuert, um niederwertige Korrekturen zu bewirken, damit niederwertige Effekte, die durch Einstellungen des Einstellelements hervorgerufen worden sind, kompensiert werden.

11. Vorrichtung nach einem der vorhergehenden Ansprüche, wobei das Einstellelement (21, 23, 25) eine Feldkrümmungs-Korrekturlinse ist.

12. Verfahren zur Herstellung eines Bauteils, das folgende Schritte umfasst:

• Bereitstellen eines Substrats (W), das zumindest teilweise mit einer Schicht aus strahlungssensitivem Material bedeckt ist;

• Bereitstellen eines Projektionsstrahls aus Strahlung unter Verwendung eines Strahlungssystems (EX, IN, CO);

• Verwenden einer Musteraufbringungseinrichtung (MA), um den Projektionsstrahl in seinem Querschnitt mit einem Muster auszustatten;

• Projizieren des gemusterten Strahls aus Strahlung auf einen Belichtungsbereich der Schicht aus strahlungssensitivem Material unter Verwendung eines Projektionssystems (PL), wobei das Projektionssystem eine Fokalebene aufweist und wenigstens ein Einstellelement (21, 23, 25) umfasst, das die Form der Fokalebene ändern kann; und

• Steuern des Einstellelements (21, 23, 25) während des Schrittes des Projizierens des gemusterten Strahls auf einen Belichtungsbereich, um die Form der Fokalebene so zu ändern, dass sie weniger flach ist und mit der Oberflächenkontur des Belichtungsbereichs genauer übereinstimmt; **dadurch gekennzeichnet, dass**

das Einstellelement ein brechendes Linsenelement (21, 23, 25) ist.

**13.** Verfahren nach Anspruch 12, ferner umfassend den Schritt des Messens der Oberflächenkontur des Belichtungsbereichs vor dem Schritt des Abbildens.

**14.** Verfahren nach Anspruch 13, wobei der Schritt des Messens unter Verwendung einer Messstation (MS) in der lithographischen Vorrichtung oder einem separaten Qualifikations-Tool ausgeführt wird.

**15.** Verfahren nach Anspruch 13 oder 14, ferner umfassend den Schritt des Berechnens von Einstellungen für das Einstellelement (21, 23, 25), um einen bestimmten Belichtungsbereich vor dem Schritt des Abbildens auf diesen Belichtungsbereich mit einer Abbildung zu versehen.

**16.** Verfahren nach Anspruch 15, wobei eine Vielzahl ähnlicher Belichtungsbereiche mit Abbildungen versehen werden und Einstellungen, die in dem Schritt des Berechnens von Einstellungen berechnet worden sind, zum Versehen mit Abbildungen auf eine Vielzahl von Belichtungsbereichen verwendet werden.

**Revendications**

**1.** Appareil de projection lithographique comprenant :

un système de rayonnement (EX, IN, CO) pour fournir un faisceau de projection de rayonnement ;

une structure de support (MT) pour supporter des moyens de mise en forme servant à mettre en forme le faisceau de projection conformément à un motif voulu ;

une table de substrat (WT) pour supporter un substrat (W) ;

un système de projection (PL) pour projeter le faisceau mis en forme sur une zone d'exposition du substrat, ledit système de projection ayant un plan focal et comprenant au moins un élément ajustable (21, 23, 25) capable de changer la forme du plan focal ; et

des moyens de commande (30) agencés pour fonctionner pendant l'exposition d'une zone d'exposition par projection dudit faisceau mis en forme sur celle-ci pour commander ledit élément ajustable pour changer la forme dudit plan focal de manière à ce qu' il soit moins plat et qu'il se conforme plus étroitement au contour de surface de ladite zone d'exposition ; **caractérisé en ce que**

ledit élément ajustable est un élément de lentille réfringent (21, 23, 25).

**2.** Appareil selon la revendication 1 dans lequel lesdits moyens de commande comprennent une mémoire pour stocker des données (31) représentatives dudit contour de surface.

**3.** Appareil selon la revendication 2 dans lequel ledit appareil comprend en outre une station de mesure (MS) ayant des moyens de mappage de hauteur de substrat agencés pour fonctionner avant une exposition pour mesurer le contour de surface de substrat d'au moins une zone d'exposition, pour stockage dans ladite mémoire.

**4.** Appareil selon la revendication 2 dans lequel lesdits moyens de commande (30) comprennent également une interface pour recevoir des données représentatives dudit contour de surface en provenance d'un dispositif externe.

**5.** Appareil selon la revendication 2, 3 ou 4 dans lequel lesdits moyens de commande (30) sont agencés pour calculer des ajustements voulus dudit élément ajustable pour une exposition donnée avant cette exposition.

6. Appareil selon la revendication 1 dans lequel ledit appareil comprend en outre un capteur pour mesurer la position de la surface de substrat en une pluralité de points dans ladite zone d'exposition pendant une exposition.

7. Appareil selon l'une quelconque des revendications précédentes comprenant également des moyens de positionnement pour déplacer ladite table de substrat (WT) pour positionner le substrat à une position et/ou orientation voulue et dans lequel lesdits moyens de commande (30) sont également opérationnels pour commander lesdits moyens de positionnement pour positionner le substrat.

8. Appareil selon la revendication 7 dans lequel lesdits moyens de commande (30) sont adaptés pour commander lesdits moyens de positionnement pour effectuer des corrections d'ordre faible pour amener la surface dudit substrat (W) sur ladite zone d'exposition en conformité plus étroite avec ledit plan focal et pour commander ledit élément ajustable pour effectuer des corrections d'ordre élevé.

9. Appareil selon la revendication 8 dans lequel lesdites corrections d'ordre faible comprennent des corrections de position et d'orientation.

10. Appareil selon la revendication 8 ou 9 dans lequel lesdits moyens de commande (30) sont adaptés pour commander ledit système de positionnement pour effectuer des corrections d'ordre faible pour compenser des effets d'ordre faible dus à des ajustements dudit élément ajustable.

11. Appareil selon l'une quelconque des revendications précédentes dans lequel ledit élément ajustable (21, 23, 25) est une lentille de correction de courbure de champ.

12. Procédé de fabrication d'un dispositif comprenant les étapes de :

fournir un substrat (W) qui est au moins partiellement recouvert d'une couche de matériau sensible au rayonnement ;
fournir un faisceau de projection de rayonnement utilisant un système de rayonnement (EX, IN, CO) ;
utiliser des moyens de mise en forme (MA) pour doter le faisceau de projection d'un motif dans sa section transversale ;
projeter le faisceau de rayonnement mis en forme sur une zone d'exposition de la couche de matériau sensible au rayonnement en utilisant un système de projection (PL), ledit système de projection ayant un plan focal et comprenant au moins un élément ajustable (21, 23, 25) capable de changer la forme du plan focal ; et

commander ledit élément ajustable (21, 23, 25), pendant l'étape de projection du faisceau mis en forme sur une zone d'exposition, pour changer la forme dudit plan focal de manière à ce qu'il soit moins plat et qu'il se conforme plus étroitement au contour de surface de ladite zone d'exposition ; **caractérisé en ce que** :

ledit élément ajustable est un élément de lentille réfringent (21, 23, 25).

13. Procédé selon la revendication 12 comprenant en outre l'étape de mesurer le contour de surface de ladite zone de l'exposition avant l'étape de reproduction.

14. Procédé selon la revendication 13 dans lequel l'étape de mesure est réalisée en utilisant une station de mesure (MS) dans l'appareil lithographique ou un outil de qualification séparé.

15. Procédé selon la revendication 13 ou 14 comprenant en outre l'étape de calculer des ajustements de l'élément ajustable (21, 23, 25) pour l'imagerie d'une zone d'exposition donnée avant l'étape d'imagerie de cette zone d'exposition.

16. Procédé selon la revendication 15 dans lequel une pluralité de zones d'exposition similaires est imagée et des ajustements calculés pendant ladite étape de calcul d'ajustements sont utilisés lors de l'imagerie d'une pluralité de zones d'exposition.

# Fig.1.

EP 1 231 515 B1

**Fig.2.**

$Z_{LS}$

W

WT

$Z_{IF}$

$Z_{Wafer}$

**Fig.3.**

LS

W

TIS

WT

$Z_{IF}$

**Fig.4.**

W

LS

TIS

WT

$Z_{IF}$

**Fig.5.**

PL

W

TIS

WT

$Z_{IF}$

**Fig.6.**

PL

W

TIS

WT

$Z_{IF}$

Fig.7.

TIS2

F

WT

W

TIS1

F

Fig.8.

22

21

24

23

26

25

PL

PB

WS

12

11

13

# Fig.9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- WO 9838597 A
- WO 9833096 A
- US 5229872 A
- US 6046792 A
- US 5969441 A
- WO 9840791 A
- EP 1037117 A

- US 5202748 A
- US 5142132 A
- WO 9828665 A
- WO 9928790 A
- WO 9932940 A
- US 4540277 A
- US 5144363 A
- EP 0467445 A
- EP 0906590 A